# EUROPÄISCHE PATENTSCHRIFT

(11) **EP 1 821 351 B1**
(45) Veröffentlichungstag und Bekanntmachung des Hinweises auf die Patenterteilung: **16.04.2008**
(21) Anmeldenummer: 06003197.8
(22) Anmeldetag: 16.02.2006
(51) Int. Cl.: H01L 41/22, H01L 41/24

(54) **Verfahren zum Herstellen eines piezoelektrischen Bauteils**
Method to produce a piezoelectric device
Méthode pour produire un dispositif piézoélectrique

(43) Veröffentlichungstag der Anmeldung: 22.08.2007
(73) Patentinhaber: Delphi Technologies, Inc., Troy, MI 48007 (US)
(72) Erfinder: Sciortino, Giacomo G., 49076 Osnabrück (DE); Goat, Christopher A., Offham, West Malling, Kent, ME19 5NU (GB)
(74) Vertreter: Manitz, Finsterwald & Partner GbR

(56) Entgegenhaltungen:
- EP-A- 1 432 048
- WO-A-03/073524
- DE-A1- 10 256 980
- DE-A1- 10 260 853

## Beschreibung

Die vorliegende Erfindung betrifft ein Verfahren zum Bestimmen der Anordnung von Elektroden bei der Herstellung eines piezoelektrischen Bauteils, insbesondere eines Piezoaktors sowie ein Verfahren zum Herstellen eines piezoelektrischen Bauteils unter Verwendung des vorgenannten Verfahrens.

Bekannte Piezoaktoren weisen üblicherweise einen Stapel alternierender (Innen)elektroden und Piezokeramikschichten auf, wobei die einzelnen Innenelektroden beidseitig von jeweils einer Piezokeramikschicht und die einzelnen Piezokeramikschichten, ausgenommen der am Rand des Stapels angeordneten, beidseitig von jeweils einer Innenelektrode umgeben sind. Dabei weisen jeweils benachbarte, durch eine Piezokeramikschicht voneinander getrennte Elektroden eine unterschiedliche Polarität auf, so dass bei Anlegen einer elektrischen Spannung zwischen jeweils zwei benachbarten Innenelektroden jeweils ein elektrisches Feld ausgebildet wird. Dies wird beispielsweise konstruktiv dadurch erreicht, dass jeweils ein Ende jeder zweiten Innenelektrode mit einer als erste Außenelektrode fungierenden und an einer ersten Seitenfläche des in der Regel quaderförmigen Piezoaktors aufgebrachten Metallschicht elektrisch leitend verbunden ist, während sich jeweils ein Ende der anderen Elektroden mit einer auf einer zweiten, der ersten gegenüberliegenden Seitenfläche des Piezoaktors aufgebrachten und als zweite Außenelektrode fungierenden Metallschicht in Kontakt befindet.

Um einen Kurzschluss zwischen den Innenelektroden einer ersten Polarität und der Außenelektrode entgegengesetzter Polarität beim Betrieb des Bauteils zu vermeiden, erstrecken sich die einzelnen Innenelektroden üblicherweise nicht über die gesamte Breite der von den beiden mit je einer Außenelektrode versehenen Seitenfläche begrenzten Querschnittsebene, sondern ausgehend von der Seitenfläche, welche die Außenelektrode gleicher Polarität aufweist, mit der die Innenelektrode verbunden ist, nur bis zu einem gewissen Abstand zu der gegenüberliegenden Seitenfläche, auf der die zweite Außenelektrode entgegengesetzter Polarität angeordnet ist. Dadurch bildet sich an den beiden jeweils mit einer Außenelektrode versehenen Seitenflächen jeweils ein sich axial erstreckender Randbereich aus, in dem sich jeweils nur Innenelektroden einer Polarität befinden. In diesen Randbereichen wird bei Anlegen einer elektrischen Spannung zwischen den Außenelektroden mithin kein elektrisches Feld erzeugt, so dass diese Randschichten piezoelektrisch inaktiv sind.

Um diese piezoelektrisch inaktiven Bereiche auf die axialen Randbereiche der beiden Seitenflächen mit daran angeordneter Außenelektrode zu beschränken, erstrecken sich die einzelnen Innenelektroden in der Querrichtung dazu durchgehend, so dass sich die einzelnen Innenelektroden bis zu den beiden Oberflächen der Seitenflächen des Piezoaktors, welche keine Außenelektrode aufweisen, erstrecken und dort freiliegen.

Idealerweise weisen die piezoelektrisch inaktiven Randbereiche über deren gesamten Länge eine konstante Breite auf. Allerdings führen die einzelnen Schritte der Herstellung eines piezoelektrischen Bauteils, nämlich Laminieren der einzelnen Schichten des Bauteils, Verpressen des Mehrschichtaufbaus, Zuschneiden und Sintern des Bauteils, zu einer Verformung des Mehrschichtaufbaus, so dass die Enden der einzelnen Elektroden in den piezoelektrisch inaktiven Randbereichen nicht exakt übereinander liegen.

Aufgrund dieser Verformung entstehen, bezogen auf die Länge des Bauteils, Abweichungen in der Breite der piezoelektrisch inaktiven Bereiche, und zwar typischerweise zufällige Abweichungen, systematische lineare Abweichungen, systematische gekrümmte Abweichungen oder eine Kombination von zwei oder mehr der vorstehenden Abweichungen.

Diese Abweichungen in der Breite der piezoelektrisch inaktiven Randbereiche stellen deshalb ein Problem dar, weil diese Bereiche während des normalen Polungsvorgangs nicht gepolt werden und daher auch keinem longitudinalen Polungswachstum unterliegen. Diese Polungsunstetigkeiten verursachen eine Kompressionsbeanspruchung in dem gepolten Bereich sowie eine Zugspannung in dem piezoelektrisch inaktiven Bereich. Sofern die piezoelektrisch inaktiven Bereiche entlang der Länge des Mehrschichtaufbaus nicht symmetrisch sind, können diese Beanspruchungen eine Verformung oder gar einen Bruch des Bauteils verursachen.

Um die Abweichungen in der Breite der piezoelektrisch inaktiven Randbereiche zu minimieren, muss bei der Herstellung des Bauteils die genaue Lage der Elektroden innerhalb des Mehrschichtaufbaus lokalisiert werden und das Bauteil gegebenenfalls mechanisch so nachbearbeitet werden, dass die Variationen in der Breite der piezoelektrisch inaktiven Randbereiche innerhalb eines akzeptablen Bereiches liegen. Bisher bekannte Verfahren zum Lokalisieren der Lage der einzelnen Elektroden in einem piezoelektrischen Mehrschichtaufbau beruhen auf einer rein optischen Erfassung der Position der Elektroden und sind entsprechend ungenau.

Ein derartiges Verfahren zur Bestimmung der Unsymmetrie der elektrisch inaktiven Zonen durch ein optisches Messverfahren ist beispielsweise aus der WO 03/073524 bekannt. In Abhängigkeit von dem Messergebnis erfolgt eine Nachbearbeitung der Außenflächen des Piezoaktors durch das Anbringen einer Fase.

Aufgabe der vorliegenden Erfindung ist es daher, ein Verfahren zum Bestimmen der Anordnung von Elektroden bei der Herstellung eines piezoelektrischen Bauteils, insbesondere eines Piezoaktors, bereitzustellen, bei dem die Lage der einzelnen Elektroden in dem Mehrschichtaufbau und insbesondere die Geometrie der piezoelektrisch inaktiven Randbereiche schnell, einfach und zuverlässig bestimmt werden kann, um aufgrund der bestimmten Lage der einzelnen Elektroden durch etwaige Nachbearbeitung des piezoelektrischen Bauteils ein Bauteil erhalten zu können, in dem die piezoelektrisch inaktiven Randbereiche entlang der Länge des Bauteils eine konstante Breite aufweisen.

Erfindungsgemäß wird diese Aufgabe gelöst durch ein Verfahren mit den Merkmalen des Patentanspruchs 1 und insbesondere durch ein Verfahren zum Bestimmen der Anordnung von Elektroden bei der Herstellung eines piezoelektrischen Bauteils, insbesondere eines Piezoaktors, umfassend die Schritte:
a) Bereitstellen eines Grundkörpers aus einem Mehrschichtaufbau aus wenigstens einer piezoelektrischen Keramikschicht und wenigstens zwei Elektroden, wobei der Grundkörper wenigstens zwei Außenflächen aufweist und sich die wenigstens zwei Elektroden zumindest bereichsweise bis zu wenigstens einer der Außenflächen erstrecken und dort mit einem Ende freiliegen, wohingegen die wenigstens zwei Elektroden auf wenigstens einer weiteren Außenfläche nicht freiliegen, sowie
b) Entfernen des Materials der wenigstens einen Außenfläche, auf der die Elektroden nicht freiliegen, mit einem Mittel, bis wenigstens eine der Elektroden mit einem Ende auf dieser Außenfläche freiliegt,
wobei das Mittel elektrisch leitfähig ist, beim Entfernen des Materials der wenigstens einen Außenfläche in Schritt b) zwischen dem Mittel und wenigstens einer der Elektroden eine elektrische Spannung angelegt wird und der beim Entfernen des Materials durch die wenigstens eine Elektrode fließende elektrische Strom gemessen wird.

Indem beim Entfernen des Materials der wenigstens einen Außenfläche, auf der die Elektroden nicht freiliegen, welches üblicherweise piezoelektrisches Keramikmaterial ist, zwischen dem elektrisch leitfähigen Mittel zum Entfernen des Materials, beispielsweise einer Schleifvorrichtung, und wenigstens einer der Elektroden eine elektrische Spannung angelegt wird und der beim Entfernen des Materials durch diese Elektrode fließende elektrische Strom gemessen wird, kann bestimmt werden, zu welchem Zeitpunkt diese Elektrode an der Außenfläche freigelegt wird, da zu diesem Zeitpunkt das Mittel zum Entfernen des Materials der wenigstens einen Außenfläche mit wenigstens einem Ende der Elektrode in Kontakt tritt, so dass aufgrund der zwischen dem Mittel und der Elektrode angelegten Spannung ein elektrischer Strom durch die Elektrode fließt. Sofern die elektrische Spannung zwischen dem Mittel und wenigstens zwei Elektroden angelegt wird, kann mit dem erfindungsgemäßen Verfahren detektiert werden, zu welchem Zeitpunkt und an welchem Ort die erste der mit elektrischer Spannung versehenen Elektroden an der entsprechenden Außenfläche freigelegt wird, da in diesem Fall diese Elektrode mit dem Mittel in elektrischen Kontakt kommt. Indem die Oberfläche eines piezoelektrischen Bauteils in einzelne Sektoren unterteilt wird und die Elektroden eines jeden Sektors jeweils mit einer unterschiedlichen Spannungsquelle verbunden werden bzw. mit einem unterschiedlichen Kanal einer Spannungsquelle verbunden werden, kann mit dem erfindungsgemäßen Verfahren festgestellt werden, zu welchem Zeitpunkt und an welcher Position jeweils die erste Elektrode eines jeden Sektors an der entsprechenden Außenfläche freigelegt wird. Durch Kenntnis der genauen Lage der jeweils pro Sektor zuerst freigelegten Elektrode, d.h. der in diesem Sektor am weitesten außen stehenden Elektrode, ist es möglich, die Geometrie der piezoelektrischen Randbereiche über die Länge des Bauteils zu bestimmen, und diese, sofern diese von der gewünschten Idealform abweicht, durch entsprechendes Nachbehandeln der Außenflächen zu der gewünschten Form zu bringen.

Zum Entfernen des Materials von der wenigstens einen Außenfläche gemäß Schritt b) des erfindungsgemäßen Verfahrens können alle dem Fachmann bekannten Techniken eingesetzt werden, mit denen piezoelektrisches Keramikmaterial von einem Mehrschichtaufbau aus Elektroden und piezoelektrischen Keramikschichten entfernt werden kann. Insbesondere hat es sich im Rahmen der vorliegenden Erfindung als vorteilhaft erwiesen, das Material von der wenigstens einen Außenfläche durch Abschleifen mit einem Schleifmittel zu entfernen.

Auch bezüglich der Art des Schleifmittels ist die vorliegende Erfindung nicht limitiert. Vorzugsweise ist das Schleifmittel ein Schleifrad.

Um eine gute elektrische Verbindung zwischen dem elektrisch leitfähigen Schleifmittel und der auf der Außenfläche des Grundkörpers freizulegenden Elektrode zu erreichen, hat es sich als vorteilhaft erwiesen, zum Entfernen des Materials ein Schleifmittel umfassend ein Metallrad, auf dessen Oberfläche abrasive Partikel angeordnet sind, einzusetzen. Aufgrund des Metallrads, welches beispielsweise aus Nickel oder einer Nickel-Chrom-Legierung bestehen kann, weist ein solches Schleifmittel eine gute elektrische Leitfähigkeit auf. Da zudem zwischen den einzelnen abrasiven Partikeln Teile der Oberfläche des Metallrads freiliegen, tritt das mit elektrischer Spannung versorgte Metallrad beim Freilegen einer Elektrode an der Außenfläche des Mehrschichtaufbaus mit der Elektrode in elektrischen Kontakt, so dass elektrischer Strom durch die Elektrode und das Metallrad fließt und die freigelegte Elektrode entsprechend detektiert werden kann.

Um eine hinreichende Schleifwirkung und Dauerhaftigkeit des Schleifmittels zu erreichen, wird in Weiterbildung des Erfindungsgedankens vorgeschlagen, auf dem Metallrad des Schleifmittels abrasive Partikel aus Diamant und/oder Bornitrid vorzusehen.

Bezüglich der Höhe der zwischen dem Mittel zum Entfernen des Materials und der wenigstens einen Elektrode anzulegenden Spannung ist das erfindungsgemäße Verfahren nicht limitiert.

Die Herstellung des Grundkörpers kann nach jedem dem Fachmann zu diesem Zweck bekannten Verfahren erfolgen. Lediglich beispielsweise sei ein Verfahren genannt umfassend die folgenden Schritte:
a₁) Aufstapeln wenigstens einer piezoelektrischen Keramikschicht und wenigstens zweier Elektroden zu einem Mehrschichtaufbau, in dem die einzelnen Schichten alternierend übereinanderliegend angeordnet sind,
a₂) Verpressen des in Schritt a₁) hergestellten Mehrschichtaufbaus,
a₃) gegebenenfalls Unterteilen des Mehrschichtaufbaus in mehrere Mehrschichtaufbauten, beispielsweise durch Zerschneiden des Stapels in mehrere kleine Stapel,
a₄) Sintern des in Schritt a₂) bzw. der in Schritt a₃) erzeugten Mehrschichtaufbauten sowie
a₅) Entfernen des Materials an wenigstens einer Außenfläche des bzw. der Mehrschichtaufbauten, bis sich wenigstens eine Elektrode zumindest bereichsweise bis zu der Außenfläche erstreckt und dort mit einem Ende freiliegt.

Zum Aufstapeln gemäß Schritt a₁) können beispielsweise einzelne piezoelektrische Keramikschichten und Elektrodenschichten alternierend übereinander gelegt werden. Alternativ dazu ist es auch möglich, mehrere, später zu verschiedenen piezoelektrischen Bauteilen gehörende Mehrschichtaufbauten parallel in einem Arbeitsschritt herzustellen. Letzteres kann beispielsweise dadurch erreicht werden, dass zum Aufstapeln gemäß Schritt a₁) abwechselnd eine oder mehrere Schicht(en) aus ungebrannter piezoelektrischer Keramik und eine Schicht aus ungebrannter piezoelektrischer Keramik, auf der jeweils in Abstand zueinander mehrere zumindest im wesentlichen quadratischförmige Metallbeschichtungen angeordnet sind, übereinander gelegt werden. Dabei bilden die jeweils übereinander liegenden, durch eine oder mehrere Schichten aus ungebrannter piezoelektrischer Keramik voneinander getrennten Metallbeschichtungen später die Innenelektroden eines piezoelektrischen Bauteils aus, wohingegen auf der gleichen Querschnittsebene benachbarte Metallbeschichtungen zu verschiedenen Bauteilen getrennt werden. Dies kann beispielsweise dadurch erreicht werden, dass das Laminat in den Zwischenbereichen zwischen den einzelnen Metallbeschichtungen in axialer Richtung zerschnitten wird.

Um die späteren piezoelektrisch inaktiven Randbereiche gewünschter Geometrie zu bilden, wird in Weiterbildung des Erfindungsgedankens vorgeschlagen, in Schritt a₁) die einzelnen Schichten so übereinander zu legen, dass die einzelnen, jeweils durch eine oder mehrere piezoelektrische Keramikschichten voneinander getrennten Elektroden in Querrichtung seitlich zueinander versetzt sind. Durch Abschleifen der entsprechenden Außenflächen in Schritt b) des erfindungsgemäßen Verfahrens werden so die piezoelektrisch inaktiven Randbereiche erhalten. Vorzugsweise liegen die Elektroden in der anderen Querrichtung bündig übereinander.

Gemäß einer weiteren bevorzugten Ausführungsform der vorliegenden Erfindung wird in Schritt a₅) an der wenigstens einen Außenfläche solange Material entfernt, bis sich alle Elektroden zumindest bereichsweise bis zu der Außenfläche erstrecken und dort freiliegen. Dadurch wird gewährleistet, dass alle Elektroden mit einer Spannungsquelle oder in Sektoren unterteilt mit verschiedenen Spannungsquellen verbunden werden können, um bei Durchführung des Schritts b) des erfindungsgemäßen Verfahrens die Position der zuerst freigelegten Elektrode bzw. der innerhalb eines Sektors zuerst freigelegten Elektrode bestimmen zu können.

Zum Freilegen der Elektroden auf der wenigstens einen Außenfläche in Schritt a₅) des erfindungsgemäßen Verfahrens kann die entsprechende Außenfläche mit einem Schleifmittel, bspw. einem Schleifrad, so lange abgeschliffen werden, bis die Enden einzelner oder aller Elektroden auf der Außenfläche freiliegen. Das Abschleifen kann dabei zum einen mit der Mantelfläche des Schleifrads oder zum anderen mit der kreisförmigen Bodenfläche des Schleifrads erfolgen. Die letztgenannte Ausführungsform hat den Vorteil, dass aufgrund der größeren Fläche der Bodenfläche verglichen mit der Mantelfläche des Schleifrads mehrere Mehrschichtaufbauten gleichzeitig abgeschliffen werden können, so dass bei gleichem Durchsatz unter milderen Schleifbedingungen, d.h. unter für die Mehrschichtaufbauten geringerer thermischer und mechanischer Belastung, gearbeitet werden kann.

Ferner hat es sich im Rahmen der vorliegenden Erfindung als vorteilhaft erwiesen, den in Schritt a) bereitgestellten Grundkörper im wesentlichen quaderförmig auszubilden, wobei die wenigstens eine piezoelektrische Keramikschicht und die wenigstens zwei Elektroden in dem Grundkörper zumindest im wesentlichen horizontal angeordnet sind und sich die Elektroden von einer Seitenfläche des Grundkörpers zu einer dazu gegenüberliegenden Seitenfläche des Grundkörpers erstrecken und jeweils mit einem Ende auf jeder der beiden Seitenflächen freiliegen.

Gemäß einer weiteren bevorzugten Ausführungsform der vorliegenden Erfindung wird in Schritt b) des Verfahrens das Material an zwei gegenüber liegenden Seitenflächen des Mehrschichtaufbaus entfernt, bis auf jeder der beiden Seitenflächen jeweils ein Ende wenigstens einer Elektrode freiliegt. Auf diese Weise wird ein piezoelektrisches Bauteil erhalten, das an zwei gegenüberliegenden Seitenflächen jeweils einen piezoelektrisch inaktiven Randbereich aufweist.

Die Art und Weise des Anlegens der elektrischen Spannung zwischen dem Mittel und wenigstens einer der Elektrode hängt davon ab, welche Informationen mit dem Verfahren gemäß der vorliegenden Erfindung erhalten werden sollen. Sofern es sich nur um ein kleines elektrisches Bauteil mit wenigen Elektrodenschichten handelt, hat es sich z. B. als ausreichend erwiesen, beim Anlegen der elektrischen Spannung zwischen dem Mittel und wenigstens einer der Elektroden auf wenigstens eine Außenfläche des Grundkörpers, auf der wenigstens eine Elektrode freiliegt, eine Außenelektrode aufzubringen und diese mit einer Spannungsquelle zu verbinden. Dadurch werden alle auf der wenigstens einen Außenfläche des Grundkörpers freiliegenden Elektroden über die Außenelektrode mit der Spannungsquelle verbunden, so dass beim Entfernen des Materials der wenigstens einen Außenfläche, auf der die Elektroden zunächst nicht freiliegen, ein signifikanter elektrischer Strom durch die Außenelektrode fließt, sobald die erste damit verbundene Innenelektrode auf der Außenfläche freigelegt wird und infolgedessen mit dem Mittel, beispielsweise einem Schleifmittel, in Kontakt tritt. Wenn die genaue Position des Schleifmittels zu diesem Zeitpunkt bekannt ist, kann durch das Einsetzen des elektrischen Stromflusses auf die genaue Position des Endes der entsprechenden Elektrode geschlossen werden. Indem derselbe Vorgang auf der der Außenfläche gegenüber liegenden Außenfläche wiederholt wird, wird auch die genaue Position der ersten auf der anderen Außenfläche frei gelegten Elektrode bestimmt, so dass aus den beiden Messpunkten auf die Geometrie und etwaige Fehlanordnung der piezoelektrisch inaktiven Randbereiche geschlossen werden kann.

Sofern größere piezoelektrische Bauteile eingesetzt werden oder eine höhere Auflösung der Geometrie der piezoelektrisch inaktiven Randbereiche in einem piezoelektrischen Bauteil erreicht werden soll, hat es sich als vorteilhaft erwiesen, zum Anlegen der elektrischen Spannung zwischen dem Mittel und wenigstens einer der Elektroden auf wenigstens einer Außenfläche des Grundkörpers, auf der wenigstens eine Elektrode freiliegt, mehrere voneinander getrennte Außenelektroden aufzubringen und jede der Außenelektroden mit einer eigenen Spannungsquelle zu verbinden. Dadurch wird im Prinzip die abzuschleifende Außenfläche in einzelne Sektoren zerlegt, wobei jeweils die auf der entsprechenden Außenfläche innerhalb dieses Sektors freiliegenden Elektroden mit einer der Außenelektroden verbunden werden. Durch diese Anordnung ist es möglich, nicht nur die Position der ersten auf der gesamten Außenfläche freigelegten Elektrode zu detektieren, sondern die Position jeder der in den einzelnen Sektoren jeweils zuerst freigelegten Elektroden. So können relativ exakte Rückschlüsse auf die Geometrie der piezoelektrisch inaktiven Randbereiche gezogen werden.

Um die Auflösung des erfindungsgemäßen Verfahrens noch weiter zu erhöhen, wird in Weiterbildung des Erfindungsgedankens vorgeschlagen, zum Anlegen der elektrischen Spannung zwischen dem Mittel und wenigstens einer der Elektroden auf zwei einander gegenüberliegenden Seitenflächen des Grundkörpers, auf denen jeweils wenigstens eine Elektrode freiliegt, jeweils mehrere voneinander getrennten Außenelektroden aufzubringen und jede der Außenelektroden mit einer Spannungsquelle zu verbinden. Damit wird die genaue Lage der jeweils auf jeder der beiden Seitenflächen pro Sektor zuerst freigelegten Elektroden erhalten, so dass ausreichend viele Messpunkte bestehen, um auf die exakte Geometrie der piezoelektrisch inaktiven Randbereiche zurück schließen zu können.

Jede der vorgenannten Ausführungsformen, insbesondere die letztgenannte Ausführungsform, lässt sich besonders einfach realisieren, wenn die wenigstens eine Außenelektrode eine elektrisch leitende Klammer ist, da diese auf den beiden gegenüberliegenden Seitenflächen des Grundkörpers einfach befestigt werden kann.

Ein weiterer Gegenstand der vorliegenden Erfindung ist ein Verfahren zum Herstellen eines piezoelektrischen Bauteils, insbesondere eines Piezoaktors, umfassend die vorgenannten Schritte, bei dem nach dem Bestimmen der Anordnung der Elektroden in dem piezoelektrischen Bauteil zur Optimierung der Elektrodenanordnung, insbesondere zum Erreichen einer gewünschten Geometrie der piezoelektrisch inaktiven Randbereiche, eine oder mehrere der Außenflächen des piezoelektrischen Bauteils auf Grundlage der erhaltenen Messwerte nachgeschliffen werden.

Piezoelektrische Bauteile, welche mit dem erfindungsgemäßen Verfahren erhältlich sind, zeichnen sich insbesondere durch eine den Anforderungen entsprechende Geometrie der piezoelektrisch inaktiven Randbereiche aus, so dass Spannungen und Verformungen des Bauteils durch Fehlstellungen innerhalb der piezoelektrisch inaktiven Randbereiche vermieden werden können.

Nachfolgend wird die vorliegende Erfindung rein beispielhaft anhand vorteilhafter Ausführungsformen und unter Bezugnahme auf die beigefügten Zeichnungen beschrieben.

Dabei zeigen:
- Fig. 1: eine perspektivische Ansicht eines in Schritt a) des erfindungsgemäßen Verfahrens bereitgestellten Grundkörpers mit elektrischen Anschlüssen,
- Fig. 2: schematisch den Verfahrensschritt b) des erfindungsgemäßen Verfahrens und
- Fig. 3: die mit dem erfindungsgemäßen Verfahren bestimmte Anordnung der piezoelektrisch inaktiven Randbereiche eines piezoelektrischen Bauteils.

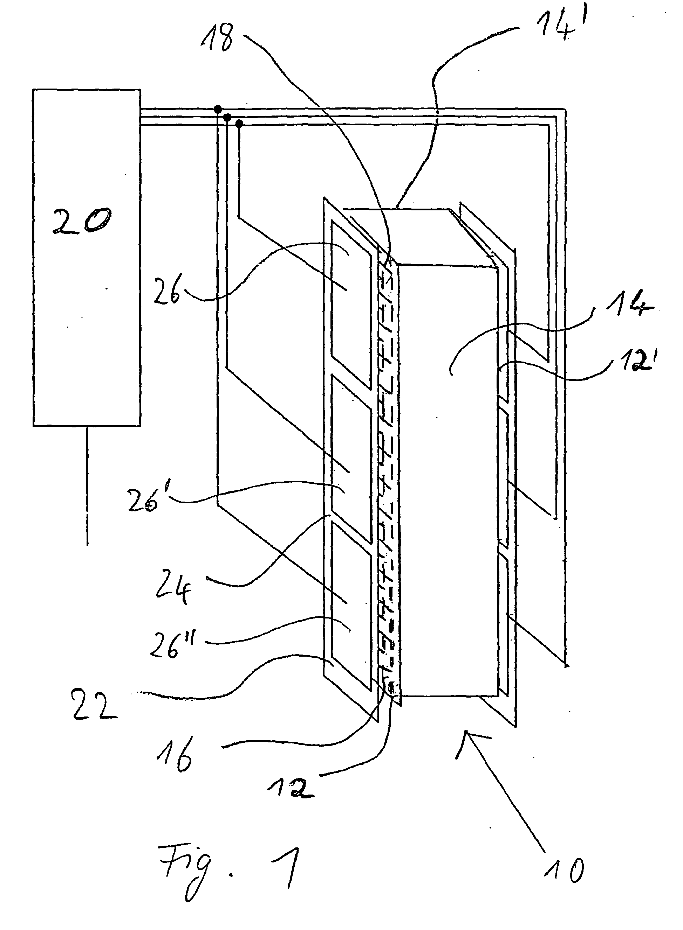

Der in der Fig. 1 schematisch dargestellte Grundkörper 10 ist quaderförmig ausgebildet und umfasst vier Seitenflächen 12, 12', 14, 14', eine Bodenfläche und eine Deckfläche. Er besteht aus alternierend angeordneten Schichten aus piezoelektrischer Keramik 16 und Elektroden 18, wobei die einzelnen Schichten 16, 18 in Form eines Stapels übereinanderliegend angeordnet sind und - ausgenommen von der obersten und untersten Schicht - jeweils eine piezoelektrische Keramikschicht 16 von zwei Elektroden 18 und jede Elektrode 18 von jeweils zwei piezoelektrischen Keramikschichten 16 umgeben ist.

Alle Elektroden 18 erstrecken sich durchgehend von der durch die Seitenflächen 12, 12' definierten Querschnittsebene, wobei jeweils ein Ende der Elektroden 18 auf den beiden Seitenflächen 12, 12' freiliegt.

Wie auf der Seitenfläche 12 in der Fig. 1 erkennbar, liegen die einzelnen Elektroden 18 in der anderen, durch die Seitenflächen 14, 14' definierten Querschnittsebene nicht bündig übereinander, sondern seitlich versetzt, so dass sich an den beiden Längsseiten des Grundkörpers 10 in der Fig. 1 gestrichelt dargestellte axiale Randbereiche ausbilden, durch die sich nur jede zweite Elektrode 18 hindurch erstreckt. Diese Randbereiche werden bei der Polung nicht gepolt, so dass diese in dem späteren piezoelektrischen Bauteil piezoelektrisch inaktiv sind. Zudem befindet sich zwischen den einzelnen Enden der Elektroden und den Seitenflächen 14, 14' piezoelektrische Keramik 16, welche entfernt werden muss, um an den entsprechenden Seitenflächen 14, 14' die jeweils seitlich zu der entsprechenden Seitenfläche 14, 14' versetzten Elektrodenenden, d.h. an der Seitenfläche 14 die Enden der ersten, dritten, fünften etc. Elektrode und an der Seitenfläche 14' die Enden der zweiten, vierten, sechsten etc. Elektrode, freizulegen.

Bevor die einzelnen Enden der Elektroden 18 auf den Seitenflächen 14, 14' freigelegt werden, werden die einzelnen Elektroden des Grundkörpers 10 an eine Spannungsquelle 20 angelegt. Hierzu werden an den beiden Seitenflächen 12, 12' jeweils Klammern 22 angelegt, die jeweils in voneinander durch elektrisch isolierendes Material 24 getrennte elektrisch leitende Sektoren 26, 26', 26" unterteilt sind. Jeder Sektor 26, 26', 26" ist jeweils mit einem unterschiedlichen Kanal der Spannungsquelle 20 verbunden. Zudem ist die Spannungsquelle mit ihrem anderen Pol mit einem Schleifrad (in der Fig. 1 nicht dargestellt) verbunden, um zwischen dem Schleifrad und den einzelnen Sektoren 26, 26', 26" bzw. den damit in Berührung stehenden Elektroden 18 eine elektrische Spannung anzulegen.

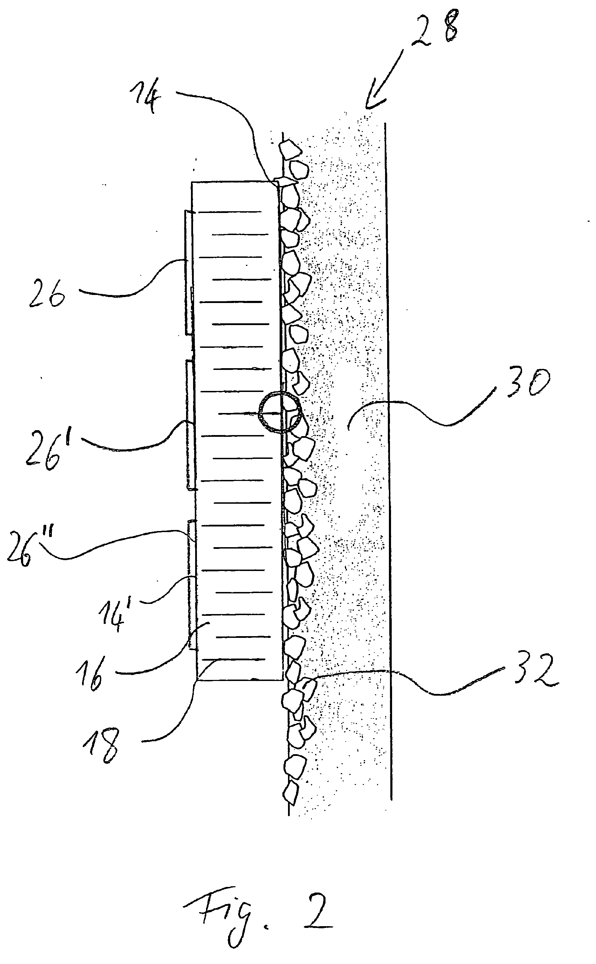

Um die einzelnen Enden der Elektroden 18 auf den Seitenflächen 14, 14' freizulegen, wird, wie in der Figur 2 dargestellt, zunächst die Seitenfläche 14 mit einem Schleifrad 28 abgeschliffen. Das Schleifrad 28 umfasst ein Metallrad 30 aus einer Nickel-Chrom-Legierung, auf dessen Schleifoberfläche abrasive Partikel 32 aus Bornitrid angeordnet sind.

Beim Schleifen wird die zu schleifende Oberfläche mit einem wasserbasierenden Kühlmittel besprüht, um eine Überhitzung des abzuschleifenden Materials zu vermeiden. Dieses Kühlmittel weist eine geringe elektrische Leitfähigkeit auf, so dass zwischen dem Schleifrad 28 und den einzelnen Elektroden 18 auf den Seitenflächen 12, 12' freigelegten Elektroden bereits ein geringer elektrischer Strom fließt, auch wenn das elektrisch leitende Metallrad 30 auf der Seitenfläche 14 noch keine Elektrode 18 berührt. Dieser geringe Stromfluss nimmt in dem Maße zu, in dem sich das Metallrad 30 den Elektroden 18 räumlich nähert. In dem Moment, wo das Metallrad 30 mit seinem darauf angeordneten abrasiven Partikeln 32 ein Ende einer Elektrode 18 auf der Seitenfläche 14 freilegt, ist das Metallrad 30 von der in der Fig. 2 durch den Kreis markierten, auf der Seitenfläche 14 freigelegten Elektrode 18 nur noch durch die Höhe der abrasiven Partikel 32, d.h. durch Bruchteile eines Mikrometers, getrennt, so dass aufgrund der zwischen dem Metallrad 30 und den Elektroden 18 angelegten Spannung ein drastischer Anstieg in dem Stromfluss durch die entsprechende Elektrode 18 auftritt. Da dieser Stromfluss auf die Elektroden 18 desjenigen Sektors 26' begrenzt ist, die mit dem gleichen Kanal der Spannungsquelle 20 verbunden sind, kann der Anstieg des Stromflusses dem Freilegen des ersten Endes einer Elektrode 18 aus dem entsprechenden Sektor 26' zugeordnet werden. Hingegen ist in den zwei anderen Kanälen der Spannungsquelle 20 zu diesem Zeitpunkt kein Stromfluss zu verzeichnen. Bei weiterem Fortschreiten des Abschleifvorgangs werden schließlich nacheinander auch die Enden der ersten Elektroden der anderen beiden Sektoren 26, 26" freigelegt, wonach auch in den entsprechenden Kanälen der Spannungsquelle 20, die diesen Sektoren 26, 26" zugeordnet sind, ein drastischer Anstieg in dem Stromfluss zu verzeichnen ist. Nach Abschluss des Schleifvorgangs sind somit die Positionen der Enden der jeweils pro Sektor 26, 26', 26" zuerst freigelegten Elektroden 18 bekannt.

Nunmehr wird derselbe Abschleifvorgang auch auf der der Seitenfläche 14 gegenüberliegenden Seitenflächen 14' wiederholt, wodurch auch die Position der auf dieser Seitenfläche 14' jeweils pro Sektor 26, 26', 26" zuerst freigelegten Elektrodenenden 18 bekannt wird. Hierzu wird der Grundkörper 10 nicht von der Klammer 22 entfernt, sondern lediglich die Klammer 22 gedreht, um die Seitenfläche 14' dem Schleifrad 28 entgegen zu richten. Dadurch wird die relative Lage des Grundkörpers in axialer Richtung nicht verändert, so dass die Lage der freigelegten Elektroden 18 in jedem Sektor 26, 26', 26" bekannt bleibt.

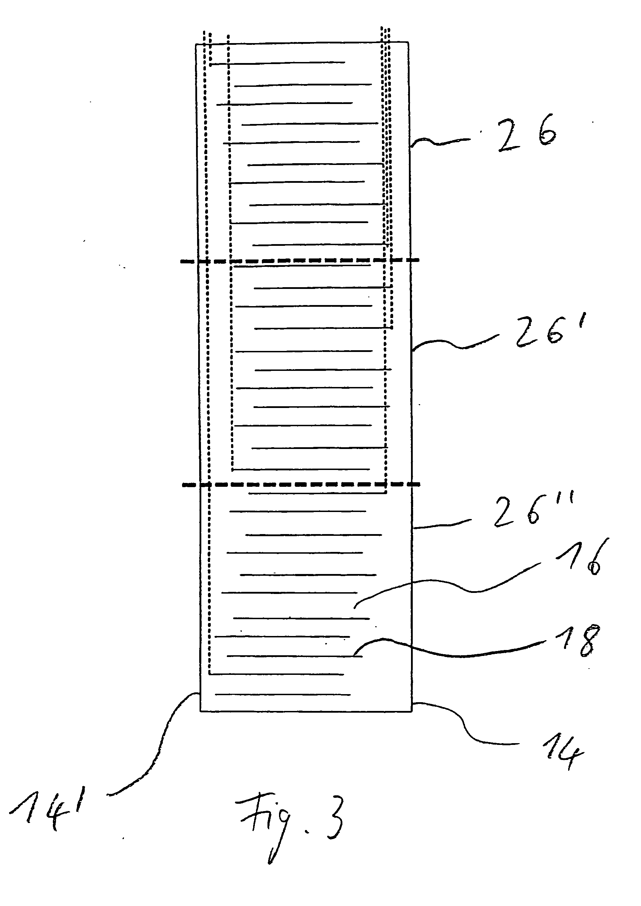

Insgesamt ergibt sich aus den so erhaltenen Ergebnissen unter der Annahme, dass die laterale Elektrodenfehlstellung entlang der axialen Richtung der Grundkörpers 10 innerhalb entsprechend kleiner Sektoren einheitlich ist, die relative Orientierung der einzelnen Elektroden 18 zueinander, wie diese beispielhaft in der Fig. 3 dargestellt ist. Dabei zeigen die gestrichelten Linien jeweils die in den einzelnen Sektoren 26, 26', 26" der beiden Seitenflächen 14, 14' zuerst freigelegten Elektroden 18. Zum Zwecke der Veranschaulichung sind in den Figuren nur drei Sektoren 26, 26', 26" dargestellt und die Fehlstellungen innerhalb der piezoelektrisch inaktiven Randbereiche übertrieben dargestellt. In Realität werden pro piezoelektrischem Bauteil weitaus mehr als drei Sektoren eingesetzt, um eine sehr genaue Auflösung der Lage der einzelnen Elektroden in dem Mehrschichtaufbau zu erhalten.

Nachdem nunmehr die relative Lage der einzelnen Elektroden zueinander und der Verlauf der piezoelektrisch inaktiven Randbereiche bekannt ist, kann durch entsprechendes Nachbearbeiten, wie Nachschleifen, der beiden Seitenflächen 14, 14' erreicht werden, dass die piezoelektrisch inaktiven Randbereiche die geforderte Form annehmen.

### Bezugszeichenliste

- 10: Grundkörper
- 12, 12': Seitenfläche mit freiliegender Elektrode
- 14, 14': Seitenfläche ohne freiliegende Elektrode
- 16: piezoelektrische Keramik
- 18: (Innen)elektrode
- 20: Spannungsquelle
- 22: Klammer
- 24: elektrisch isolierendes Material
- 26, 26', 26": elektrisch leitender Sektor
- 28: Schleifrad
- 30: Metallrad
- 32: abrasive Partikel

## Patentansprüche

1. Verfahren zum Bestimmen der Anordnung von Elektroden bei der Herstellung eines piezoelektrischen Bauteils, insbesondere eines Piezoaktors, umfassend die Schritte:
a) Bereitstellen eines Grundkörpers (10) aus einem Mehrschichtaufbau aus wenigstens einer piezoelektrischen Keramikschicht (16) und wenigstens zwei Elektroden (18), wobei der Grundkörper (10) wenigstens zwei Außenflächen (12, 12', 14, 14') aufweist und sich wenigstens eine Elektrode (18) zumindest bereichsweise bis zu wenigstens einer der Außenflächen (12, 12') erstreckt und dort mit einem Ende freiliegt, wohingegen die wenigstens zwei Elektroden auf wenigstens einer weiteren Außenfläche (14, 14') nicht freiliegen, sowie
b) Entfernen des Materials der wenigstens einen Außenfläche (14, 14'), auf der die Elektroden (18) nicht freiliegen, mit einem Mittel (28), bis wenigstens eine der Elektroden (18) mit einem Ende auf dieser Außenfläche (14, 14') freiliegt,
**dadurch gekennzeichnet, dass**
das Mittel (28) elektrisch leitfähig ist, beim Entfernen des Materials der wenigstens einen Außenfläche (14, 14') in Schritt b) zwischen dem Mittel (28) und wenigstens einer der Elektroden (18) eine elektrische Spannung angelegt wird und der beim Entfernen des Materials durch die wenigstens eine Elektrode (18) fließende elektrische Strom gemessen wird.

2. Verfahren nach Anspruch 1,
**dadurch gekennzeichnet, dass**
das Entfernen des Materials in Schritt b) durch Schleifen mit einem Schleifmittel (28), bevorzugt einem Schleifrad (28), erfolgt.

3. Verfahren nach Anspruch 2,
**dadurch gekennzeichnet, dass**
das Schleifmittel (28) ein Metallrad (30) umfasst, auf dessen Oberfläche abrasive Partikel (32) angeordnet sind.

4. Verfahren nach Anspruch 3,
**dadurch gekennzeichnet, dass**
das Metallrad (30) aus Nickel oder einer Nickel-Chrom-Legierung besteht und/oder die abrasiven Partikel (32) aus Diamant und/oder Bornitrid bestehen.

5. Verfahren nach einem der vorhergehenden Ansprüche,
**dadurch gekennzeichnet, dass**
zur Bereitstellung des Grundkörpers (10) gemäß Schritt a) folgende Schritte durchgeführt werden:
a₁) Aufstapeln wenigstens einer piezoelektrischen Keramikschicht (16) und wenigstens zweier Elektroden (18) zu einem Mehrschichtaufbau, in dem die einzelnen Schichten (16, 18) alternierend übereinanderliegend angeordnet sind,
a₂) Verpressen des in Schritt a₁) hergestellten Mehrschichtaufbaus,
a₃) ggf. Unterteilen des Mehrschichtaufbaus in mehrere Mehrschichtaufbauten,
a₄) Sintern des bzw. der Mehrschichtaufbauten sowie
a₅) Entfernen des Materials an wenigstens einer Außenfläche (12, 12') des bzw. der Mehrschichtaufbauten, bis sich wenigstens eine Elektrode (18) zumindest bereichsweise bis zu der wenigstens einen Außenfläche (12, 12') erstreckt und dort mit einem Ende freiliegt.

6. Verfahren nach Anspruch 5,
**dadurch gekennzeichnet, dass**
zum Aufstapeln gemäß Schritt a₁) abwechselnd eine oder mehrere Schicht(en) aus ungebrannter piezoelektrischer Keramik (16) und eine Schicht aus ungebrannter piezoelektrischer Keramik, auf der, vorzugsweise durch Aufdrucken, jeweils in Abstand zueinander mehrere zumindest im Wesentlichen quadratischförmige Metallbeschichtungen angeordnet sind, übereinander gelegt werden.

7. Verfahren nach Anspruch 5 oder 6,
**dadurch gekennzeichnet, dass**
die einzelnen Schichten in Schritt a₁) so übereinander gelegt werden, dass die einzelnen, jeweils durch eine oder mehrere piezoelektrische Keramikschicht(en) (16) voneinander getrennten Elektroden (18) in einer Querrichtung seitlich zueinander versetzt sind, wohingegen die Elektroden (18) vorzugsweise in der anderen Querrichtung bündig übereinander liegen.

8. Verfahren nach einem der Ansprüche 5 bis 7,
**dadurch gekennzeichnet, dass**
in Schritt a₅) so lange Material an wenigstens einer Außenfläche (12, 12') entfernt wird, bis sich alle Elektroden (18) zumindest bereichsweise bis zu der Außenfläche (12, 12') erstrecken und dort mit einem Ende freiliegen.

9. Verfahren nach einem der vorhergehenden Ansprüche,
**dadurch gekennzeichnet, dass**
der in Schritt a) bereitgestellte Grundkörper (10) im Wesentlichen quaderförmig ausgebildet ist, wobei die wenigstens eine piezoelektrische Keramikschicht (16) und die wenigstens zwei Elektroden (18) in dem Grundkörper (10) zumindest im Wesentlichen horizontal angeordnet sind und sich die Elektroden (18) von einer Seitenfläche (12, 12') des Grundkörpers zu einer gegenüberliegenden Seitenfläche (12', 12) des Grundkörpers erstrecken und jeweils mit einem Ende auf jeder der beiden Seitenflächen (12, 12') freiliegen.

10. Verfahren nach einem der vorhergehenden Ansprüche,
**dadurch gekennzeichnet, dass**
in Schritt b) das Material an zwei einander gegenüberliegenden Seitenflächen (14, 14') des Mehrschichtaufbaus entfernt wird, bis auf jeder der beiden Seitenflächen (14, 14') jeweils wenigstens ein Ende wenigstens einer Elektrode (18) freiliegt.

11. Verfahren nach einem der vorhergehenden Ansprüche,
**dadurch gekennzeichnet, dass**
zum Anlegen der elektrischen Spannung zwischen dem Mittel (28) und wenigstens einer der Elektroden (18) auf wenigstens einer Außenfläche (12, 12') des Grundkörpers (10), auf der wenigstens eine Elektrode (18) freiliegt, mehrere voneinander getrennte Außenelektroden (26, 26', 26") aufgebracht werden und jede der Außenelektroden (26, 26', 26") mit einer eigenen Spannungsquelle (20) verbunden wird.

12. Verfahren nach Anspruch 11,
**dadurch gekennzeichnet, dass**
zum Anlegen der elektrischen Spannung zwischen dem Mittel (28) und wenigstens einer der Elektroden (18) auf zwei einander gegenüberliegenden Seitenflächen (12, 12') des Grundkörpers (10), auf denen jeweils wenigstens eine Elektrode (18) freiliegt, jeweils mehrere voneinander getrennte Außenelektroden (26, 26', 26") aufgebracht werden und jede der Außenelektroden (26, 26', 26") mit einer Spannungsquelle (20) verbunden wird.

13. Verfahren zum Herstellen eines piezoelektrischen Bauteils, insbesondere eines Piezoaktors, umfassend ein Verfahren nach einem der Ansprüche 1 bis 12 und ggf. abschließendes Nachschleifen wenigstens einer Außenfläche, um die Elektrodenanordnung zu optimieren.

## Claims

1. A method for the determination of the arrangement of electrodes in the manufacture of a piezoelectric component, in particular of a piezoactuator, comprising the steps:
a) providing a base body (10) made of a multilayer structure consisting of at least one piezoelectric ceramic layer (16) and at least two electrodes (18), with the base body (10) having at least two outer surfaces (12, 12', 14, 14') and at least one electrode (18) extending at least regionally up to at least one of the outer surfaces (12, 12') and being exposed at one end there, whereas the at least two electrodes are not exposed on at least one further outer surface (14, 14'); and
b) removing the material of the at least one outer surface (14, 14') on which the electrodes (18) are not exposed using a means (28) until at least one of the electrodes (18) is exposed at one end on this outer surface (14, 14'),
**characterized in that**
the means (28) is electrically conductive; an electrical voltage is applied between the means (28) and at least one of the electrodes (18) on the removal of the material of the at least one outer surface (14, 14') in step b); and the electrical current flowing through the at least one electrode (18) is measured on the removal of the material.

2. A method in accordance with claim 1, **characterized in that** the removal of the material in step b) takes place by grinding using a grinding medium (28), preferably a grinding wheel (28).

3. A method in accordance with claim 2, **characterized in that** the grinding medium (28) comprises a metal wheel (30) on whose surface abrasive particles (32) are arranged.

4. A method in accordance with claim 3, **characterized in that** the metal wheel (30) consists of nickel or of a nickel chromium alloy and/or the abrasive particles (32) consist of diamond and/or boron nitride.

5. A method in accordance with any one of the preceding claims, **characterized in that** the following steps are carried out for the provision of the base body (10) in accordance with step a):
a₁) stacking of at least one piezoelectric ceramic section (16) and of at least two electrodes (18) to form a multilayer structure in which the individual layers (16, 18) are arranged disposed alternately over one another;
a₂) pressing of the multilayer structure manufactured in step a₁);
a₃) optionally, dividing the multilayer structure into a plurality of multilayer structures;
a₄) sintering of the multilayer structure or structures; and
a₅) removal of the material at at least one outer surface (12, 12') of the multilayer structure or structures until at least one electrode (18) extends at least regionally up to the at least one outer surface (12, 12') and is exposed at one end there.

6. A method in accordance with claim 5, **characterized in that**, for the stacking in accordance with step a₁), one or more layers of unfired piezoelectric ceramic material (16) and a layer of unfired piezoelectric ceramic material, on which in each case a plurality of at least substantially square-shaped metal coatings are arranged, preferably by printing, spaced apart from one another, are alternately placed over one another.

7. A method in accordance with claim 5 or claim 6, **characterized in that** the individual layers are placed over one another in step a₁) such that the individual electrodes (18) respectively separated from one another by one or more piezoelectric ceramic layers (16) are offset laterally with respect to one another in a transverse direction, whereas the electrodes (18) preferably lie in alignment over one another in the other transverse direction.

8. A method in accordance with any one of the claims 5 to 7, **characterized in that**, in step a₅), material is removed at at least one outer surface (12, 12') for so long until all the electrodes (18) extend at least regionally up to the outer surface (12, 12') and are exposed at one end there.

9. A method in accordance with any one of the preceding claims, **characterized in that** the base body (10) made available in step a) is substantially made in parallelepiped shape, with the at least one piezoelectric ceramic layer (16) and the at least two electrodes (18) being arranged at least substantially horizontally in the base body (10) and the electrodes (18) extending from one side surface (12, 12') of the base body to an oppositely disposed side surface (12', 12) of the base body and respectively being exposed at one end on each of the two side surfaces (12, 12').

10. A method in accordance with any one of the preceding claims, **characterized in that**, in step b), the material is removed at two mutually oppositely disposed side surfaces (14, 14') of the multilayer structure until in each case at least one end of at least one electrode (18) is exposed on each of the two side surfaces (14, 14').

11. A method in accordance with any one of the preceding claims, **characterized in that**, for the application of the electrical voltage between the means (28) and at least one of the electrodes (18) on at least one outer surface (12, 12') of the base body (10) on which at least one electrode (18) is exposed, a plurality of mutually separate outer electrodes (26, 26', 26") are applied and each of the outer electrodes (26, 26', 26") is connected to its own voltage source (20).

12. A method in accordance with claim 11, **characterized in that**, for the application of the electrical voltage between the means (28) and at least one of the electrodes (18) on two mutually oppositely disposed side surfaces (12, 12') of the base body (10) on which in each case at least one electrode (18) is exposed, in each case a plurality of mutually separate outer electrodes (26, 26', 26") are applied and each of the outer electrodes (26, 26', 26") is connected to a voltage source (20).

13. A method for the manufacture of a piezoelectric component, in particular of a piezoactuator, comprising a method in accordance with any one of the claims 1 to 12 and, optionally, final regrinding of at least one outer surface to optimize the electrode arrangement.

## Revendications

1. Procédé de détermination de la disposition d'électrodes lors de la fabrication d'un composant piézo-électrique, en particulier celle d'un actionneur piézo-électrique, comprenant les étapes suivantes :
a) la mise à disposition d'un corps de base (10) constitué d'une structure multicouche composée d'au moins une couche céramique (16) et d'au moins deux électrodes (18), le corps de base (10) présentant au moins deux surfaces extérieures (12, 12', 14, 14'), et au moins une électrode (18) s'étendant au moins par secteurs jusqu'à l'une au moins des surfaces extérieures (12, 12'), l'une de ses extrémités y étant exposée, alors que lesdites au moins deux électrodes reliées à au moins une autre surface extérieure (14, 14') ne sont pas exposées, ainsi que
b) l'enlèvement de la matière de ladite au moins une surface extérieure (14, 14'), à laquelle les électrodes (18) ne sont pas exposées, à l'aide d'un moyen (28), jusqu'à ce qu'une extrémité de l'une au moins des électrodes (18), au niveau de cette surface extérieure, soit exposée,
**caractérisé en ce que**
le moyen (28) est électriquement conducteur, et, pendant l'enlèvement de la matière de ladite au moins une surface extérieure (14, 14') à l'étape b), une tension électrique est appliquée entre le moyen (28) et au moins une des électrodes (18), et que le courant électrique traversant ladite au moins une électrode (18) pendant l'enlèvement de la matière est mesuré.

2. Procédé selon la revendication 1, **caractérisé en ce que** l'enlèvement de la matière pendant l'étape b) est effectué par abrasion au moyen d'un produit abrasif, de préférence au moyen d'une meule (28).

3. Procédé selon la revendication 2, **caractérisé en ce que** le produit abrasif (28) comprend une roue métallique (30) à la surface de laquelle sont disposées des particules abrasives (32).

4. Procédé selon la revendication 3, **caractérisé en ce que** la roue métallique (30) est réalisée en nickel ou en un alliage de nickel-chrome et/ou que les particules abrasives (32) sont constituées de diamant et/ou de nitrure de bore.

5. Procédé selon l'une des revendications précédentes, **caractérisé en ce que**, pour la mise à disposition du corps de base (10) selon l'étape a), les étapes suivantes sont exécutées :
a₁) empilage d'au moins une couche céramique piézo-électrique (16) et d'au moins deux électrodes (18) en une structure multicouche, dans laquelle les différentes couches (16, 18) sont disposées en alternance les unes au-dessus des autres,
a₂) compression de la structure multicouche produite au cours de l'étape a₁),
a₃) le cas échéant, division de la structure multicouche en plusieurs structures multicouches,
a₄) frittage de la ou des structure(s) multicouche(s), ainsi que
a₅) enlèvement de la matière sur l'une au moins des surfaces extérieurs (12, 12') de la ou des structure(s) multicouche(s), jusqu'à ce qu'au moins une électrode (18) s'étende au moins par secteurs jusqu'à ladite au moins une surface extérieure (12, 12'), et que l'une de ses extrémités y soit exposée.

6. Procédé selon la revendication 5, **caractérisé en ce que**, pour l'empilement selon l'étape a₁), on superpose, en alternance, une ou plusieurs couche(s) d'un matériau céramique piézo-électrique (16) non cuit, et une couche d'un matériau céramique piézo-électrique non cuit sur laquelle ont été déposés, de préférence par impression, plusieurs revêtement métalliques espacés les uns des autres, au moins essentiellement parallélépipèdes.

7. Procédé selon la revendication 5 ou 6, **caractérisé en ce que** les différentes couches sont superposées les unes sur les autres, au cours de l'étape a₁), de manière telle que les électrodes individuelles (18) séparées les unes des autres par une ou plusieurs couche(s) céramique(s) piézo-électrique(s) (16) soient latéralement décalées les unes par rapport aux autres dans une direction transversale, alors que les électrodes (18) se superposent de préférence en alignement les unes avec les autres, dans l'autre direction transversale.

8. Procédé selon l'une des revendications 5 à 7, **caractérisé en ce que**, pendant l'étape a₅), de la matière est enlevée d'au moins une surface extérieure (12, 12') jusqu'à ce que toutes les électrodes (18) s'étendent, par secteurs au moins, jusqu'à la surface extérieure (12, 12'), une de leurs extrémités y étant exposée.

9. Procédé selon l'une des revendications précédentes, **caractérisé en ce que** le corps de base (10) mis à disposition dans l'étape a) est configuré selon une forme essentiellement parallélépipède, ladite au moins une couche céramique piézo-électrique (16) et lesdites au moins deux électrodes (18) sont disposées au moins essentiellement horizontalement dans le corps de base (10), et que les électrodes (18) s'étendent d'une surface latérale (12, 12') du corps de base à une surface latérale opposée (12', 12) du corps de base, et qu'une de leurs extrémités est exposée à chacune des deux surfaces latérales (12, 12').

10. Procédé selon l'une des revendications précédentes, **caractérisé en ce qu'**à l'étape b), la matière est enlevée à deux surfaces latérales opposées (14, 14') de la structure multicouche, jusqu'à ce que, à chacune des deux surfaces latérales (14, 14'), respectivement au moins une extrémité d'au moins une électrode (18) soit exposée.

11. Procédé selon l'une des revendications précédentes, **caractérisé en ce que**, pour appliquer une tension électrique entre le moyen (28) et l'une au moins des électrodes (18), plusieurs électrodes extérieures (26, 26', 26") séparées les unes des autres sont déposées sur l'une au moins des surfaces extérieures (12, 12') du corps de base (10), où au moins une électrode (18) est exposée, et que chacune des électrodes extérieures (26, 26', 26") est reliée à une source de tension (20) qui lui est propre.

12. Procédé selon la revendication 11, **caractérisé en ce que**, pour appliquer une tension électrique entre le moyen (28) et au moins une des électrodes (18), des électrodes extérieures (26, 26', 26") séparées les unes des autres sont déposées sur deux surfaces latérales opposées (12, 12') du corps de base (10), où respectivement au moins une électrode (18) est exposée, et que chacune des électrodes extérieures (26, 26', 26") est reliée à une source de tension (20).

13. Procédé de fabrication d'un composant piézo-électrique, en particulier d'un actionneur piézo-électrique, comprenant un procédé selon l'une des revendications 1 à 12, suivi le cas échéant d'un traitement de retouche de polissage d'au moins une surface extérieure de manière à optimiser l'agencement d'électrodes.
